(19) **Europäisches Patentamt** / **European Patent Office** / **Office européen des brevets**

(11) **EP 4 055 400 B1**

(12) ## EUROPÄISCHE PATENTSCHRIFT

(45) Veröffentlichungstag und Bekanntmachung des Hinweises auf die Patenterteilung:
**09.10.2024 Patentblatt 2024/41**

(21) Anmeldenummer: **20803811.7**

(22) Anmeldetag: **06.11.2020**

(51) Internationale Patentklassifikation (IPC):
**G01R 31/40** (2020.01)    **H02J 3/00** (2006.01)

(52) Gemeinsame Patentklassifikation (CPC):
**G01R 31/40;** G01R 31/2848; H02J 2203/20;
Y02E 60/00; Y04S 40/20

(86) Internationale Anmeldenummer:
**PCT/EP2020/081365**

(87) Internationale Veröffentlichungsnummer:
**WO 2021/089830 (14.05.2021 Gazette 2021/19)**

(54) **VORRICHTUNG ZUR EMULATION EINES VERSORGUNGSNETZES ZUR VALIDIERUNG VON KOMPONENTEN EINES STROMVERSORGUNGSSYSTEMS**

APPARATUS FOR EMULATING A SUPPLY NETWORK FOR VALIDATING COMPONENTS OF A POWER SUPPLY SYSTEM

APPAREIL POUR ÉMULER UN RÉSEAU D'ALIMENTATION AFIN DE VALIDER DES COMPOSANTS D'UN SYSTÈME D'ALIMENTATION ÉLECTRIQUE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **08.11.2019 DE 102019217291**

(43) Veröffentlichungstag der Anmeldung:
**14.09.2022 Patentblatt 2022/37**

(73) Patentinhaber: **Rheinisch-Westfälische Technische Hochschule (RWTH) Aachen 52062 Aachen (DE)**

(72) Erfinder:
• **MONTI, Antonello**
  **52072 Aachen (DE)**
• **UHL, Robert**
  **52072 Aachen (DE)**
• **GURUMURTHY, Sriram Karthik**
  **52074 Aachen (DE)**

(74) Vertreter: **RCD-Patent Giesen, Schmelcher & Griebel Patentwanwälte PartG mbB Postfach 3106 52118 Herzogenrath (DE)**

(56) Entgegenhaltungen:
**US-A1- 2014 015 555    US-A1- 2019 067 939**

• **SI GUANGYE ET AL: "Development of a power-hardware-in-the-loop application - Power grid emulator by using 'voltage source inverter cumul", 2015 IEEE APPLIED POWER ELECTRONICS CONFERENCE AND EXPOSITION (APEC), IEEE, 15 March 2015 (2015-03-15), pages 2181 - 2188, XP032774952, DOI: 10.1109/APEC.2015.7104651**
• **SI GUANGYE ET AL: "Switch mode converter based high performance power-hardware-in-the-loop grid emulator", 2016 IEEE 2ND ANNUAL SOUTHERN POWER ELECTRONICS CONFERENCE (SPEC), IEEE, 5 December 2016 (2016-12-05), pages 1 - 6, XP033059570, DOI: 10.1109/SPEC.2016.7846010**
• **JONKE PETER ET AL: "Concept of a three phase AC power source with virtual output impedance for tests of grid connected components", 2015 INTERNATIONAL SYMPOSIUM ON SMART ELECTRIC DISTRIBUTION SYSTEMS AND TECHNOLOGIES (EDST), IEEE, 8 September 2015 (2015-09-08), pages 399 - 404, XP032812150, DOI: 10.1109/SEDST.2015.7315242**

EP 4 055 400 B1

• SI GUANGYE ET AL: "Extending the Power Capability With Dynamic Performance of a Power-Hardware-in-the-Loop Application-Power Grid Emulator Using "Inverter Cumulation"", IEEE TRANSACTIONS ON INDUSTRY APPLICATIONS, IEEE SERVICE CENTER, PISCATAWAY, NJ, US, vol. 52, no. 4, 1 July 2016 (2016-07-01), pages 3193 - 3202, XP011616939, ISSN: 0093-9994, [retrieved on 20160715], DOI: 10.1109/TIA.2016.2539918

**Beschreibung**

Hintergrund

In den vergangenen Jahren ist ein zunehmender Trend zu komplizierten elektrischen Netzen festzustellen. Dies ist zum einen darin begründet, dass immer mehr elektrische Verbraucher an solche Netze angeschlossen werden als auch darin, dass die Zahl der Quellen, die in elektrische Netze speisen, durch die zunehmende Anzahl von Energie-Erzeugern aus regenerativen Quellen zunimmt.

Dabei ist auch eine zunehmende Komplexität feststellbar. Waren am Ende des letzten Jahrtausends eine kleine Zahl von Kraftwerken auf einer relativ hohen Ebene der Netztopologie (Transportnetz) angesiedelt und die Verbraucher im Wesentlichen auf unteren Ebenen, so ist durch die sogenannte Energiewende eine zunehmende Anzahl von Energie-Erzeugern auf einer unteren Ebene der Netztopologie zu finden.

Sowohl auf Seiten der Energieerzeugung als auch Seiten der Verbraucher sind dabei elektronische Schaltungen mit frequenz-gesteuerter Leistungselektronik anzutreffen.

In der Vergangenheit wurde daher bereits begonnen einzelne Komponenten vor einer Inbetriebnahme zu testen bzw. bezüglich ihres Verhaltens in einem Elektrizitätsversorgungsnetz zu validieren. So ist es bekannt, dass z.B. auch aus normativen Anforderungen, wie der IEEE 1547-2018, IEC 61000-3-15:2011, IEC 61000-4-11:2019 oder IEC 62116:2014, heraus bestimmte Anwendungen validiert werden müssen.

War in klassischen Netzen alleine die Netzfrequenz bestimmend, ist nunmehr festzustellen, dass diese Vielzahl von elektronischen Schaltungen mit frequenz-gesteuerter Leistungselektronik sich gegenseitig beeinflussen und aufeinander in unterschiedlichem Maß rückkoppeln.

Insbesondere im Fall der Zusammenschaltung mehrerer Inverter und Wandler kann es zu Instabilitäten kommen. Diese können z.B. darin begründet sein, dass die Bandbreiten der Regelung hoch sind, NichtLinearitäten durch Phasen-Regel-Schleifen eingeführt werden oder Impedanz-Überschneidungen der Eingangs- und Ausgangsimpedanzen (im Bode-Diagramm) auftreten. Weiterhin können Serien- sowie Parallelresonanzen entstehen, beispielsweise von Netzfiltern der Inverter mit im Versorgungsnetz vorhandenen Induktivitäten bzw. der Netzimpedanz. Die so gebildeten Serien- sowie Parallelresonanzen können dann durch Spannungs- oder Stromharmonische angeregt werden, so dass harmonische Instabilität droht.

Mit der zunehmenden Verbreitung solcher Komponenten werden zunehmend Stabilitätsprobleme auftreten, da die idealisierten Validierungsverfahren der Vergangenheit ein ideales, starres Netz annehmen und daher solche Szenarien nicht sicher abdecken können.

Im Allgemeinen können die bisherigen Ansätze in zwei Kategorien unterteilt werden, nämlich klassische Netzemulatoren, die sich als ideale Spannungsquelle mit beliebigen Wellenformen innerhalb der Bandbreite darstellen, und als sogenannte Power-Hardware-in-the-Loop Aufbauten, die eine Echtzeitemulation eines Versorgungsnetzes mit einem Leistungsverstärker kombinieren.

Es sind Ansätze bekannt, bei denen die Impedanz eines Versorgungsnetzes in erster Ordnung mittels eines Widerstandes und einer Reaktanz in einem einphasigen Netzemulator nachgebildet wird. Weiterhin sind Ansätze bekannt, bei denen das Klemmenverhalten einer elektrischen Last mittels eines geschalteten Leistungsverstärkers emuliert wird. Hierdurch können im Wesentlichen zwei verschieden Arten von Lasten, eine statische Last bzw. eine induktive Last entsprechend eines Motors, emuliert werden. Diese Ansätze lassen sich auch auf dreiphasige Systeme erweitern.

Ansätze, die Impedanzen erster Ordnung berücksichtigen, sind beispielsweise aus der Patentanmeldung US 2004 / 015 555 A1, US 2019 / 067 939 A1 sowie aus den Artikeln "Development of a power-hardware-in-the-loop application - Power grid emulator by using 'voltage source inverter cumul" der Autoren SI GUANGYE ET AL, veröffentlicht in 2015 IEEE APPLIED POWER ELECTRONICS CONFERENCE AND EXPOSITION (APEC), IEEE, (20150315), doi:10.1109/APEC.2015.7104651, Seiten, "Switch mode converter based high performance power-hardware-in-the-loop grid emulator" der Autoren SI GUANGYE ET AL, veröffentlicht in 2016 IEEE 2ND ANNUAL SOUTHERN POWER ELECTRONICS CONFERENCE (SPEC), IEEE, (20161205), doi:10.1109/SPEC.2016.7846010, Seiten 1 - 6, sowie "Concept of a three phase AC power source with virtual output impedance for tests of grid connected components" der Autoren JONKE PETER ETAL veröffentlicht in 2015 INTERNATIONAL SYMPOSIUM ON SMART ELECTRIC DISTRIBUTION SYSTEMS AND TECHNOLOGIES (EDST), IEEE, (20150908), doi:10.1109/SEDST.2015.7315242, Seiten 399 - 404, bekannt.

Weiterhin sind klassische kommerzielle Netzemulatoren, wie z.B. Regatron TC.ACS, Chroma 61800 series, NH Research 9410 Regenerative Grid Simulator oder California Instruments MX Series II, bekannt. Bei diesen klassischen Netzemulatoren werden vorberechnete Wellenformen verwendet, mit denen z.B. bestimmte Phänomene, wie z.B. Spannungsschwankungen, Spannungsharmonische, Kurzunterbrechungen etc. rückwirkungsfrei (da ideale Spannungsquelle) emuliert werden können.

Dabei wird implizit von der Annahme eines starren Versorgungsnetzes ausgegangen. Diese Annahme impliziert, dass eine Rückkoppelung zwischen dem durch den Netzemulator emulierten Versorgungsnetz und der zu validierenden Komponente nicht existiert. Somit können aus einer solchen Rückkopplung resultierende Instabilitäten mit einem klassischen Netzemulator nicht nachgebildet werden.

Der Netzemulator Regatron TC.ACS ermöglicht es für bestimmte von Normen vorgeschriebene Tests mit Invertern zusätzliche zu einem starren Versorgungsnetz einen RLC-Kreis an seinem Ausgang zu emulieren. Weiterhin ermöglichen einige klassische kommerzielle Netzemulatoren zusätzliche die Emulation von RLC-Lasten anstelle eines Versorgungsnetzes. Weiterhin sind aus den chinesischen Patentanmeldungen CN 104852616 A und CN 106487240 A, sowie aus dem chinesischen Patent CN 106487240 B verwandte Ansätze zu erkennen, bei denen in erster Näherung Impedanzen von Versorgungsleitungen als Verschaltung eines Widerstandes, einer Spule und eines Kondensators, d.h. für ein eng-begrenztes Model, angesehen werden.

Der alternative Ansatz des Power-Hardware-in-the-Loop-Aufbaus hat sich bisher als sehr kostspielig herausgestellt. Hier wird ein Leistungsverstärker und eine Echtzeitsimulationsplattform (beispielsweise RTDS oder OPAL-RT) verwendet, wobei die Echtzeitsimulationsplattform die Antwort der zu verifizierenden Komponente in Form eines Netzmodells berücksichtigt. Die große Herausforderung besteht hier für die Anwender darin, geeignete Modelle für verschiedene Versorgungsnetz zu entwickeln, da dies zeitintensiv und damit auch kostenintensiv ist.

Dennoch sind die vorgenannten Ansätze ungeeignet typische Bedingungen in einem (belasteten) Versorgungsnetz und das komplexe Verhalten einer zu validierenden Komponente, wie beispielsweise einem Photovoltaikinverter, im Zusammenspiel mit einem Versorgungsnetz in einem realistischen Maßstab abzubilden.

Aufgabe

Ausgehend hiervon ist es eine Aufgabe der Erfindung eine Vorrichtung anzugeben, mit der die Stabilität verschiedener Versorgungsnetze im Zusammenspiel mit zu validierenden Komponenten abgeschätzt werden können.

Kurzdarstellung der Erfindung

Die Aufgabe wird gelöst durch eine Vorrichtung gemäß Anspruch 1. Weitere vorteilhafte Ausgestaltungen sind Gegenstand der abhängigen Ansprüche, der Beschreibung und der Figuren.

Kurzdarstellung der Figuren

Nachfolgend wird die Erfindung näher unter Bezug auf die Figuren erläutert. In diesen zeigt:

     Fig. 1 ein verallgemeinerter Aufbau eines Netzemulators zur Erläuterung der Erfindung,
     Fig. 2 ein Ersatzschaltbild für ein Quellen-Last-System zur Verdeutlichung der Erfindung,

     Fig. 3a ein Ersatzschaltbild mit äquivalenten Impedanzen zur Verdeutlichung der Erfindung,
     Fig. 3b ein Ersatzschaltbild mit äquivalenter Admittanz (komplexer Leitwert) zur Verdeutlichung der Erfindung.

Ausführliche Darstellung der Erfindung

Nachfolgend wird die Erfindung eingehender unter Bezugnahme auf die Figuren dargestellt. Dabei ist anzumerken, dass unterschiedliche Aspekte beschrieben werden, die jeweils einzeln oder in Kombination zum Einsatz kommen können. D.h. jeglicher Aspekt kann mit unterschiedlichen Ausführungsformen der Erfindung verwendet werden, soweit nicht explizit als reine Alternative dargestellt und soweit dies den Ansprüchen entspricht.

Weiterhin wird nachfolgend der Einfachheit halber in aller Regel immer nur auf eine Entität Bezug genommen werden. Soweit nicht explizit vermerkt, kann die Erfindung aber auch jeweils mehrere der betroffenen Entitäten aufweisen. Insofern ist die Verwendung der Wörter "ein", "eine" und "eines" nur als Hinweis darauf zu verstehen, dass in einer einfachen Ausführungsform zumindest eine Entität verwendet wird.

Soweit nachfolgend Verfahren beschrieben werden, sind die einzelnen Schritte eines Verfahrens in beliebiger Reihenfolge anordbar und/oder kombinierbar, soweit sich durch den Zusammenhang nicht explizit etwas Abweichendes ergibt. Weiterhin sind die Verfahren - soweit nicht ausdrücklich anderweitig gekennzeichnet - untereinander kombinierbar.

Angaben mit Zahlenwerten sind in aller Regel nicht als exakte Werte zu verstehen, sondern beinhalten auch eine Toleranz von +/- 1% bis zu +/- 10 %.

Bezugnahme auf Standards oder Spezifikationen oder Normen sind als Bezugnahme auf Standards bzw. Spezifikationen bzw. Normen, die zum Zeitpunkt der Anmeldung und/oder soweit eine Priorität beansprucht wird - zum Zeitpunkt der Prioritätsanmeldung gelten/galten zu verstehen. Hiermit ist jedoch kein genereller Ausschluss der Anwendbarkeit auf nachfolgende oder ersetzende Standards oder Spezifikationen oder Normen zu verstehen.

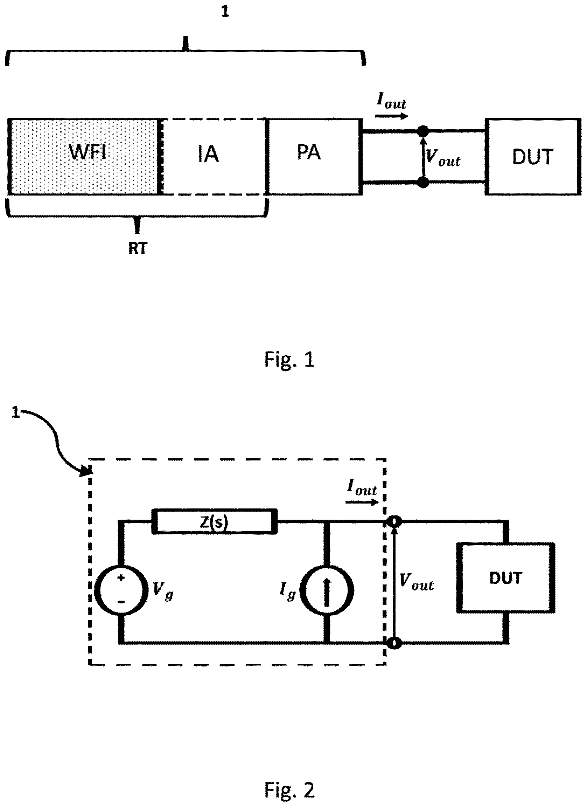

In einer Ausführungsform der Erfindung - welche in den Figuren 1, 2, 3a und 3b - skizziert ist - wird eine Vorrichtung 1 zur Emulation eines Versorgungsnetzes zur Validierung von Komponenten DUT eines Stromversorgungssystems bereitgestellt.

Die zu validierende Komponente wird im englischen Sprachgebrauch auch als Device under Test, abgekürzt DUT, bezeichnet. Validierung ist dabei so zu verstehen, dass das Verhalten einer zu validierenden Komponente DUT unter realistischen Bedingungen eines Versorgungsnetzes getestet wird, um so gefährliche Situationen, die im Netz durch Steuerung der Komponente, z.B. Steuerungsvorgängen in der Strom- / Spannungs-Versorgung der Komponenten (z.B. in einem Schaltnetzteil) hervorgerufen werden könnte, zu verhindern.

Hierzu weist die Vorrichtung 1 Mittel RT zur Bereitstellung eines Strom-/Spannungs-Signales entsprechend einer frequenzabhängigen Impedanz eines vorgebbaren Versorgungsnetzes auf. Das Strom-/Spannungs-Signal dieser Mittel RT kann z.B. einer Echtzeitsimulation eines Netzes entstammen. Typischerweise kann hierfür wie in Figur 1 gezeigt, ein Netzimpedanzmodel WFI (wideband frequency impedance) und ein optionales Schnittstellenmodel IA verwendet werden. Das emulierte Netzimpedanzmodell WFI kann z.B. eine frequenzabhängige Netzimpedanz niedriger Ordnung, wie eine RL- oder RLC-Schaltung, aber auch eine frequenzabhängige Netzimpedanz beliebiger höherer Ordnung sein. Die Mittel RT zur Bereitstellung eines Strom-/Spannungs-Signales werden nachfolgend auch als Versorgungsnetz-Emulator beschrieben.

Weiterhin weist die Vorrichtung 1 Mittel PA zur Verstärkung des bereitgestellten Strom-/Spannungs-Signales auf. Das so bereitgestellte Strom-/Spannungs-Signal kann dann an eine zu validierende Komponente DUT gegeben werden. Das Mittel PA zur Verstärkung kann z.B. ein geeigneter Leistungsverstärker sein.

Zur Validierung weist die Vorrichtung 1 weiterhin Mittel SI zur Messung des Stromes $I_{out}$, welcher aus der Vorrichtung in die angeschlossene Komponente DUT fließt, und Mittel SU zur Messung der Spannung $V_{out}$, welche effektiv an der angeschlossenen Komponente DUT anliegt, auf. Die Mittel SI und SU können integriert in der Vorrichtung 1 am Ausgang angeordnet sein oder außerhalb der Vorrichtung 1, z.B. zwischen der Vorrichtung 1 und er angeschlossenen Komponente DUT.

Um das Mittel PA zur Verstärkung und die Mittel RT zur Bereitstellung eines Strom-/Spannungs-Signales geeignet aneinander anzupassen kann die Schnittstelle geeignet über ein optionales Schnittstellenmodel IA angepasst sein. Das einfachste Schnittstellenmodell IA ist das sogenannte ideale Transformator-Modell (ITM), ein komplexeres ist das gedämpfte Impedanz-Modell (DIM), um nur zwei Interfacemodelle zu benennen. Andere Schnittstellenmodelle IA sind hierdurch nicht ausgeschlossen.

Figur 1 zeigt dabei die interne logische Struktur einer Vorrichtung 1 im Zusammenspiel mit einer zu verifizierenden Komponente DUT auf. Dabei wird ein Modell der breitbandigen frequenzabhängigen Impedanz WFI und ein Mittel PA zur Verstärkung des bereitgestellten Strom-/Spannungs-Signales als Teil einer Echtzeitsimulation RT bereitgestellt. Das Mittel PA zur Verstärkung des bereitgestellten Strom-/Spannungs-Signales, beispielsweise ein Leistungsverstärker, wirkt als Strom- oder Spannungsquelle, je nach Anforderungen an den Testaufbau bzw. die zu validierende Komponente DUT.

Der Ausgangsstrom $I_{out}$ und die Ausgangsspannung $V_{out}$ am Ausgang der Vorrichtung 1 werden in die Echtzeitsimulation RT zurückgekoppelt, sodass ein geschlossener Kreis in diesem Power-Hardware-in-the-Loop-Aufbau bereitgestellt ist.

In Figur 2 ist die breitbandige frequenzabhängige Impedanz (wideband-frequency Impedanz, abgek. WFI) $Z(s)$ des Versorgungsnetzes als Modell dargestellt.

Die Wellenformen der Spannung $V_g$ als auch des Stromes $I_g$ kann dabei frei eingestellt werden, um ein Verhalten gegenüber unterschiedlichen Netzzuständen zu testen. Dabei ergibt sich lediglich die Bandbreite der Vorrichtung 1 als Grenze. Dabei werden sowohl die Schnittstellenmodelle IA als auch die Mittel PA zur Verstärkung des bereitgestellten Strom- / Spannungs-Signales unter der Annahme eines idealen Verhaltens in Figur 2 ausgeblendet. Dies ist für die Modellfindung für die Vorrichtung 1 jedoch unerheblich.

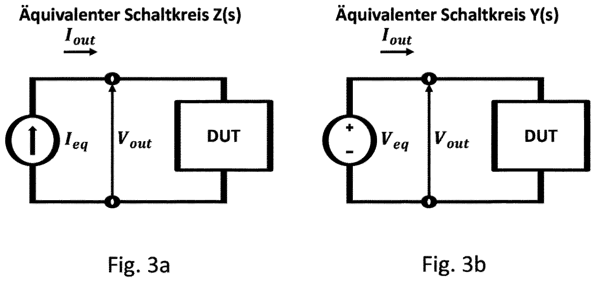

Basierend auf einer gegebenen breitbandigen frequenzabhängigen Impedanz $Z(s)$ des Versorgungsnetzes kann ein kontinuierliches bzw. diskretes Zustandsraummodell entwickelt werden. Dieses kann, siehe Figuren 3a und 3b, als äquivalente Strom- oder Spannungsquelle angesehen werden. Im Falle, dass die Übertragungsfunktion der WFI nicht kausal ist, kann ein Zustandsraummodell der äquivalenten breitbandigen frequenzabhängigen Admittanz (engl. wideband-frequency admittance, abgek.

$$\text{WFA)} \ Y(s) = \frac{1}{Z(s)}$$ entwickelt werden.

Aus verschiedenen Gründen, wie den Eigenschaften des betrachteten DUT oder Anforderungen an den Aufbau, kann es notwendig sein, die zuvor beschriebenen Zustandsraummodelle der gegebenen breitbandigen frequenzabhängigen Impedanz bzw. Admittanz des Versorgungsnetzes zwingend als Spannungs- oder Stromquelle zu formulieren. Hierbei muss ggf. das Impedanz- oder Admittanz-Modell zuvor in eine kausale Form umformuliert werden.

Ein einfaches Beispiel erster Ordnung könnte z.B. $Z(s) = R + s \cdot L$ sein, wobei hier die Übertragungsfunktion der WFI nicht kausal ist. Hier kann jedoch das Zustandsraummodell der äquivalenten breitbandigen frequenzabhängigen Admittanz

$$Y(s) = \frac{1}{Z(s)} = \frac{1}{R + s \cdot L}$$ entwickelt werden. Durch beispielsweise die Nutzung eines Tiefpass-Filters erster Ordnung lässt sich die Übertragungsfunktion der WFI $Z(s)$ jedoch auch in eine kausale Form überführen. Das so erhaltene Zustandsraummodell (sei es als Impedanz $Z(s)$ oder als Admittanz $Z(s)$) kann nun um die die Spannungsquelle $V_g$ und die Stromquelle $I_g$ erweitert werden, vgl. Figur 2.

Die applizierten Spannungen bzw. Ströme können - jedenfalls bis zur Bandbreite des Versorgungsnetzemulators Vorrichtung 1 - jede beliebige Form aufweisen, d.h. insbesondere sowohl fundamentale Bestandteile (Netzfrequenz) als auch Harmonische, Zwischenharmonische und Gleichanteile aufweisen.

Im Falle, dass eine WFI verwendet wurde, wird das Modell entsprechend Figur 3a (d.h. eine Stromquelle) verwendet. Dabei stellt der äquivalente Schaltkreis des Versorgungsnetzes am Ausgang eine Stromquelle dar, wobei am Eingang des äquivalenten Schaltkreises des Versorgungsnetzes die Ausgangsspannung angenommen wird.

Im Falle, dass eine WFA verwendet wurde, wird das Modell entsprechend Figur 3b (d.h. eine Spannungsquelle) verwendet. Dabei stellt der äquivalente Schaltkreis des Versorgungsnetzes am Ausgang eine Spannungsquelle dar, wobei am Eingang des äquivalenten Schaltkreises des Versorgungsnetzes der Ausgangsstrom angenommen wird.

Obwohl in Figuren 3a und 3b nur der einphasige Fall dargestellt ist, kann der mehrphasige Fall, insbesondere der dreiphasige Fall, ohne Weiteres in gleicher Weise abgeleitet werden.

Um die äquivalente Schaltung des Versorgungsnetzes WFI- oder WFA-Modells, nämlich die Echtzeitemulation, die das Verhalten des Versorgungsnetzes emuliert, mit dem Mittel PA zur Verstärkung zu verbinden, können verschiedene Schnittstellenmodelle IA verwendet werden.

Ein einfaches Schnittstellenmodell IA ist ein ideales Transformatormodell (ITM). Dabei sei angemerkt, dass solche (idealen) Transformatormodelle häufig den Nachteil von Stabilitätseinschränkungen aufweisen.

Ein DIM-Schnittstellenalgorithmus (Dämpfungsmethode) kann dagegen eine Schätzung der WFI des DUT verwenden, um das zugrundeliegende Power-Hardware-in-the-Loop-Aufbaus aus Mittel RT und PA mit dem DUT zu stabilisieren. Dabei könnte bei einer perfekten Schätzung des WFI des DUTs absolute Stabilität erreicht werden. Aber auch bei kleinen Fehlern in der Schätzung des WFIs ist die Stabilität des Power-Hardware-in-the-Loop-Aufbaus im Vergleich zum ITM-Ansatz erheblich verbessert. Die Systemidentifikationsmethode über einen breiten Frequenzbereich (wideband system identification, abgek. WSI), die von dem nachfolgend erwähnten Versorgungsnetz WFI-Messgerät (Patentanmeldung DE 102019214533.7 des gleichen Anmelders) verwendet wird, kann ebenfalls zur Messung der WFI des DUTs genutzt werden. Die WSI-Methode kann hierzu in den Versorgungsnetz-Emulator integriert werden, um die Robustheit des Versorgungsnetz-Emulators für verschiedene angeschlossene DUTs zu erreichen.

In einer Ausführungsform der Erfindung wird die WFI bzw. WFA für das vorgebbare Versorgungsnetz aus einer Datenbank ausgewählt. Dies können die breitbandigen frequenzabhängigen Impedanz-/Admittanz-Daten eines realen zuvor gemessenen Netzes sein oder modellierte Daten. Die Daten können in einer lokalen Datenbank gespeichert sein, aus einer entfernten Datenbank abgerufen oder von einem Speichermedium geladen werden. Hierfür können die üblichen Schnittstellen, wie z.B. eine Verbindung in ein Datenkommunikationsnetz (Internet) und/oder Anschlüsse an entsprechende Lesegeräte bzw. die Lesegeräte selbst in der Vorrichtung 1 vorgesehen sein. Dabei können z.B. typische Szenarien oder länderspezifische Anforderungen Berücksichtigung finden. Reale Daten können mit Vorrichtungen gemäß der deutschen Patentanmeldung DE 102019214533.7 des gleichen Anmelders und der gleichen Erfinder erhoben werden.

Der Benutzer wird somit in die Lage versetzt, eine zu validierende Komponente eines Versorgungsnetzes unter einer Vielzahl von Bedingungen (sequentiell) zu testen, ohne dass ein tieferes Verständnis von Versorgungsnetzen und ihren Eigenschaften notwendig wird.

Ohne Beschränkung der Allgemeinheit ist die Erfindung dazu geeignet, dass das zu emulierende Netz ein Wechselspannungsnetz ist. Insbesondere kann das zu emulierende Netz ein einphasiges oder mehrphasiges Wechselspannungsnetz sein.

Andererseits kann das zu emulierende Netz auch ein Gleichspannungsnetz sein. Insbesondere kann das zu emulierende Netz ein monopolares oder bipolares Gleichspannungsnetz sein.

Die Erfindung ermöglicht es daher auf einfache Weise realistische Testbedingungen für die Validierung von Komponenten in einem elektrischen Versorgungsnetz zur Verfügung zu stellen. Dabei können mittels der Erfindung unterschiedliche Teststandards (z.B. entsprechend bestimmter Testvorgaben, bestimmter Spannungswerte etc.) bereitgestellt werden. Dabei wird auf das Modell der frequenzabhängigen (breitbandigen) Impedanz zurückgegriffen. Dies ermöglicht es Effekte, die mit klassischen Ansätzen nicht sichtbar waren, nunmehr darzustellen.

D.h. durch die Berücksichtigung der frequenzabhängigen Impedanz/Admittanz eines vorgebbaren Versorgungsnetzes kann auch ein transientes Verhalten einer Komponente im Zusammenspiel mit einem Versorgungsnetz dargestellt werden. Dies ist mit bisherigen Ansätzen nicht möglich.

Je nach Komplexität einer gegebenen WFI bzw. WFA eines Versorgungsnetzes kann die Zahl der (harmonischen) Spannungen / Ströme, die benötigte Bandbreite der Mittel PA zur Verstärkung etc. hohe Anforderungen an die Rechenleistung im Sinne einer Echtzeitsimulation RT stellen. Daher kann die Echtzeitsimulation RT beispielsweise mittels geeigneter DSPs (Digital Signal Processor) und/oder mittels geeigneter FPGAs (Field-Programmable Gate Array) oder ASICs (Application-Specific Integrated Circuit) einzeln oder im Verbund bereitgestellt sein.

Dabei ist die nötige Bandbreite der Vorrichtung 1 und damit des Versorgungsnetz-Emulators größer, bevorzugt mindestens zumindest doppelt so groß, zu wählen wie die höchste Frequenz (einer Resonanz), die zu berücksichtigen ist.

Die zu modellierenden Resonanzfrequenzen der WFI des Versorgungsnetzes hängen dabei z.B. von den Filtern in Invertern des Versorgungsnetzes und damit von den Schaltfrequenzen der Inverter ab.

Die erfindungsgemäße Vorrichtung 1 kann auf bestehenden Plattformen klassischer Netzemulatoren durch eine entsprechende Softwareerweiterung aufbauen. Hierdurch können erhebliche Kosten bei der Hardwareentwicklung eingespart werden.

Ebenso ist es denkbar mehrere Vorrichtungen 1 parallel zu betreiben, um z.B. höhere Leistungen zur Verfügung stellen zu können.

Im Vergleich zu dem bisherigen Ansatz, der mit einem vollwertigen Power-Hardware-in-the-Loop-Aufbau der eingangs beschriebenen Art verwendet wird, erspart die Erfindung einen erheblichen Aufwand, da kein solcher kostspieliger Aufbau angeschafft und betrieben werden muss. Ein Ansatz gemäß der Erfindung ist dabei auch erheblich flexibler und nutzerfreundlicher, denn die Entwicklung des für einen Power-Hardware-in-the-Loop-Aufbau notwendigen Netzmodells ist sehr aufwändig, erfordert hoch-spezialisiertes Wissen und ist zeitintensiv. Weiterhin können durch eine Kombination der Regelung des Verstärkers (PA) sowie der Echtzeitsimulation (RT) auf einer gemeinsamen Rechenplattform sonst üblicherweise auftretende Verzögerungen zwischen PA und RT eliminiert werden.

Aber auch im Vergleich zu klassischen Netzemulatoren, die ein starres Netz emulieren, bietet die Erfindung Vorteile, denn die Erfindung ermöglicht es bisher nicht berücksichtigte Effekte zu untersuchen.

**Patentansprüche**

1. Vorrichtung (1) zur Emulation eines Versorgungsnetzes zur Validierung von Komponenten (DUT) eines Stromversorgungssystems, aufweisend

 • Mittel (RT) zur Bereitstellung eines Strom-/Spannungs-Signales entsprechend einer frequenzabhängigen Impedanz eines vorgebbaren Versorgungsnetzes,
 • Mittel (PA) zur Verstärkung des bereitgestellten Strom-/Spannungs-Signales,
 • Mittel (SI) zur Messung des Stromes, welcher aus der Vorrichtung in die angeschlossene Komponente (DUT) fließt und
 • Mittel (SU) zur Messung der Spannung, welche effektiv an der angeschlossenen Komponente (DUT) anliegt,
 • wobei in Betrieb der Ausgangsstrom $I_{out}$ und die Ausgangsspannung $V_{out}$ an die Mittel (RT) zur Bereitstellung eines Strom-/Spannungs-Signales zurückgekoppelt werden, sodass ein geschlossener Kreis in diesem Power-Hardware-in-the-Loop-Aufbau bereitgestellt wird,

 **gekennzeichnet dadurch,**
 **dass** die frequenzabhängige Impedanz eines vorgebbaren Versorgungsnetzes eines emulierten Netzimpedanzmodells (WFI) eine beliebige höhere Ordnung aufweist.

2. Vorrichtung (1) nach Anspruch 1, **dadurch gekennzeichnet, dass** das vorgebbare Versorgungsnetz aus einer Datenbank ausgewählt werden kann.

3. Vorrichtung (1) nach einem der vorhergehen Ansprüche, **dadurch gekennzeichnet, dass** das zu emulierende Netz ein Wechselspannungsnetz ist.

4. Vorrichtung (1) nach einem der vorhergehen Ansprüche, **dadurch gekennzeichnet, dass** das zu emulierende Netz ein einphasiges oder mehrphasiges Wechselspannungsnetz ist.

5. Vorrichtung (1) nach einem der vorhergehen Ansprüche 1 bis 2, **dadurch gekennzeichnet, dass** das zu emulierende Netz ein Gleichspannungsnetz ist.

6. Vorrichtung (1) nach Anspruch 5, **dadurch gekennzeichnet, dass** das zu emulierende Netz ein monopolares oder bipolares Gleichspannungsnetz ist.

**Claims**

1. A device (1) for emulating a supply network for validating components (DUT) of a power supply system, comprising

 • means (RT) for providing a current/voltage signal corresponding to a frequency-dependent impedance of a specifiable supply network,
 • means (PA) for amplifying the provided current/voltage signal,
 • means (SI) for measuring the current flowing from the device into the connected component (DUT) and
 • means (SU) for measuring the voltage that is effectively applied at the connected component (DUT),
 • wherein, in operation, the output current $I_{out}$ and the output voltage $V_{out}$ are fed back to the means (RT) for providing a current/voltage signal so that a closed circuit is provided in this power-hardware-in-the-loop setup,

 **characterized in that**
 the frequency-dependent impedance of a specifiable supply network of an emulated network impedance model (WFI) is of any higher order.

2. The device (1) according to claim 1, **characterized in that** the specifiable supply network can be selected from a database.

3. The device (1) according to one of the preceding claims, **characterized in that** the network to be emulated is an alternating voltage network.

**4.** The device (1) according to one of the preceding claims, **characterized in that** the network to be emulated is a single-phase or polyphase alternating voltage network.

**5.** The device (1) according to one of the preceding claims 1 to 2, **characterized in that** the network to be emulated is a direct voltage network.

**6.** The device (1) according to claim 5, **characterized in that** the network to be emulated is a is a monopolar or bipolar direct voltage network.

**Revendications**

**1.** Dispositif (1) d'émulation d'un réseau d'alimentation pour valider des composants (DUT) d'un système d'alimentation électrique, comprenant

 • des moyens (RT) pour fournir un signal de courant/tension correspondant à une impédance dépendant de la fréquence d'un réseau d'alimentation prédéterminé,
 • des moyens (PA) pour amplifier le signal de courant/tension fourni,
 • des moyens (SI) pour mesurer le courant qui circule du dispositif vers le composant connecté (DUT) et
 • des moyens (SU) pour mesurer la tension qui est effectivement appliquée aux composants connectés (DUT),
 • dans lequel, pendant le fonctionnement, le courant de sortie $I_{out}$ et la tension de sortie $V_{out}$ sont réinjectés dans les moyens (RT) pour fournir un signal de courant/tension, de sorte qu'un circuit fermé dans cette structure de matériel d'alimentation-dans-la-boucle soit fourni,

 **caractérisé en ce que** l'impédance dépendant de la fréquence d'un réseau d'alimentation prédéterminé d'un modèle d'impédance de réseau (WFI) émulé présente un ordre supérieur quelconque.

**2.** Dispositif (1) selon la revendication 1, **caractérisé en ce que** le réseau d'alimentation prédéterminable peut être sélectionné à partir d'une base de données.

**3.** Dispositif (1) selon une des revendications précédentes, **caractérisé en ce que** le réseau à émuler est un réseau à tension alternative.

**4.** Dispositif (1) selon une des revendications précédentes, **caractérisé en ce que** le réseau à émuler est un réseau à tension alternative monophasé ou multiphasé.

**5.** Dispositif (1) selon l'une des revendications précédentes 1 à 2, **caractérisé en ce que** le réseau à émuler est un réseau à tension continue.

**6.** Dispositif (1) selon la revendication 5, **caractérisé en ce que** le réseau à émuler est un réseau de tension continue monopolaire ou bipolaire.

1

Fig. 1

Fig. 2

**Äquivalenter Schaltkreis Z(s)**

$I_{out}$

$I_{eq}$  $V_{out}$  DUT

Fig. 3a

**Äquivalenter Schaltkreis Y(s)**

$I_{out}$

$V_{eq}$  $V_{out}$  DUT

Fig. 3b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2004015555 A1
- US 2019067939A1 A
- CN 104852616 A
- CN 106487240 A
- CN 106487240 B
- DE 102019214533

**In der Beschreibung aufgeführte Nicht-Patentliteratur**

- Development of a power-hardware-in-the-loop application - Power grid emulator by using 'voltage source inverter cumul. **AUTOREN SI GUANGYE et al.** 2015 IEEE APPLIED POWER ELECTRONICS CONFERENCE AND EXPOSITION (APEC). IEEE, 15. Marz 2015
- Switch mode converter based high performance power-hardware-in-the-loop grid emulator. **SI GUANGYE et al.** 2016 IEEE 2ND ANNUAL SOUTHERN POWER ELECTRONICS CONFERENCE (SPEC). IEEE, 05. Dezember 2016, 1-6
- Concept of a three phase AC power source with virtual output impedance for tests of grid connected components. **JONKE PETER.** 2015 INTERNATIONAL SYMPOSIUM ON SMART ELECTRIC DISTRIBUTION SYSTEMS AND TECHNOLOGIES (EDST). IEEE, 08. September 2015, 399-404